Europäisches Patentamt

**European Patent Office**

Office européen des brevets

(10)

(11) Publication number: **0 283 481**

**B1**

(12) **EUROPEAN PATENT SPECIFICATION**

(45) Date of publication of patent specification: **14.11.90**

(21) Application number: **87905347.8**

(22) Date of filing: **27.07.87**

(86) International application number:
**PCT/US87/01774**

(87) International publication number:
**WO 88/02183 24.03.88 Gazette 88/07**

(51) Int. Cl.⁵: **H 01 L 21/70**

(54) **TRIMMING PASSIVE COMPONENTS BURIED IN MULTILAYER STRUCTURES.**

(30) Priority: **19.09.86 US 910109**

(43) Date of publication of application:
**28.09.88 Bulletin 88/39**

(45) Publication of the grant of the patent:
**14.11.90 Bulletin 90/46**

(84) Designated Contracting States:
**DE FR GB SE**

(56) References cited:
**EP-A-0 108 314**

**Solid State Technology, vol. 29, no. 1, January 1986, (Port Washington, N.Y., US), J.I. Steinberg et al.: "Low temperature co-fired tape dielectric material systems for multilayer interconnections", pages 97-101**

(73) Proprietor: **Hughes Aircraft Company**
**7200 Hughes Terrace P.O. Box 45066**
**Los Angeles, California 90045-0066 (US)**

(72) Inventor: **POND, Ramona, G.**
**10903 Dalwood Avenue**
**Downey, CA 90241 (US)**
Inventor: **VITRIOL, William, A.**
**1505 W. Rene Drive**
**Anaheim, CA 92802 (US)**
Inventor: **BROWN, Raymond, L.**
**10432 Falcon Avenue**
**Fountain Valley, CA 92708 (US)**

(74) Representative: **Colgan, Stephen James et al**
**CARPMAELS & RANSFORD 43 Bloomsbury Square**
**London WC1A 2RA (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The disclosed invention generally relates to the precision trimming of passive components in hybrid multilayer circuit structures, and more particularly is directed to a technique for trimming resistors, capacitors and other passive components buried in hybrid multilayer circuit structures.

Hybrid multilayer circuit structures, also known as hybrid microcircuits, implement the interconnection and packaging of discrete circuit devices, and generally include a plurality of dielectric layers respectively having predetermined conductor traces and conductive vias. Generally, the discrete circuit devices are mounted on the top dielectric layer.

Known techniques for fabricating multilayer circuit structures include thick film technology and dielectric tape technology. With thick film technology, each dielectric layer is individually deposited in paste form and then fired. With dielectric tape technology, each dielectric layer is made of dielectric tape. The layers may be sequentially applied and fired (referred to as the tape transfer process), or the entire laminate of layers may be fired at one time (referred to as the cofired process).

The use of precision resistors and/or capacitors with hybrid multilayer circuit structures has generally been a compromise between area available for circuit elements and discrete circuit device packing density. For example, precision resistors have been utilized in the form of either trimmable thick film resistors printed on the top dielectric layer (surface resistors) or discrete chip resistors which are mounted on the top dielectric layer along with the discrete circuit devices. Similarly, trimmable capacitors may be printed on the top dielectric layer (surface capacitors). Such use of the top dielectric layer for resistors or capacitors reduces the area that would otherwise be available for discrete circuit devices.

In search of higher packing densities, efforts have been made to include passive circuit components, such as resistors and capacitors, in the processing of multilayer circuit structures. Such components may be buried in the hybrid multilayer circuits, or they may be formed on the top dielectric layer.

However, the values of buried resistors and capacitors made pursuant to known techniques are difficult to precisely control, and therefore are unsuitable where precision resistors or capacitors are required. Moreover, buried resistors and capacitors have not been trimmable since they are buried. Surface resistors and capacitors formed on the top dielectric layer are amenable to laser trimming and are utilized as precision resistors and capacitors. Such surface resistors and capacitors are covered with a glass passivation layer, and trimming is achieved with laser equipment which cuts through the glass layer to selectively remove resistive material or capacitor plate material.

An important consideration with utilizing surface resistors and capacitors is the reduced device packing density that results from allocating area on the top dielectric layer to such passive circuit components. A further consideration with utilizing surface resistors and capacitors is the necessity of extra processing steps to provide a glass passivation layer.

Summary of the Invention

It would therefore be an advantage to provide a technique for trimming passive components that are formed between dielectric layers of a hybrid multilayer circuit structure.

It would also be an advantage to provide for trimming passive circuit components in a hybrid multilayer circuit structure which do not require glass passivation layers.

Another advantage would be to provide for trimmable passive components that may be buried in a hybrid multilayer circuit structure.

The foregoing and other advantages and features are provided by the method of the invention which includes the steps of (a) forming a passive circuit component between two dielectric layers of a hybrid multilayer circuit structure, (b) processing the multilayer circuit structure to provide a fired multilayer circuit structure, and (c) selectively removing part of the material of the passive circuit component to trim the passive component.

Brief Description of the Drawing

The advantages and features of the disclosed invention will readily be appreciated by persons skilled in the art from the following detailed description when read in conjunction with the drawing wherein:

FIG. 1 schematically illustrates a hybrid multilayer circuit structure having buried twin resistors which may be trimmed in accordance with the invention.

FIG. 2 schematically illustrates trimming of a buried thick film resistor in accordance with the invention.

Detailed Description of the Disclosure

In the following detailed description and in the several figures of the drawing, like elements are identified with like reference numerals.

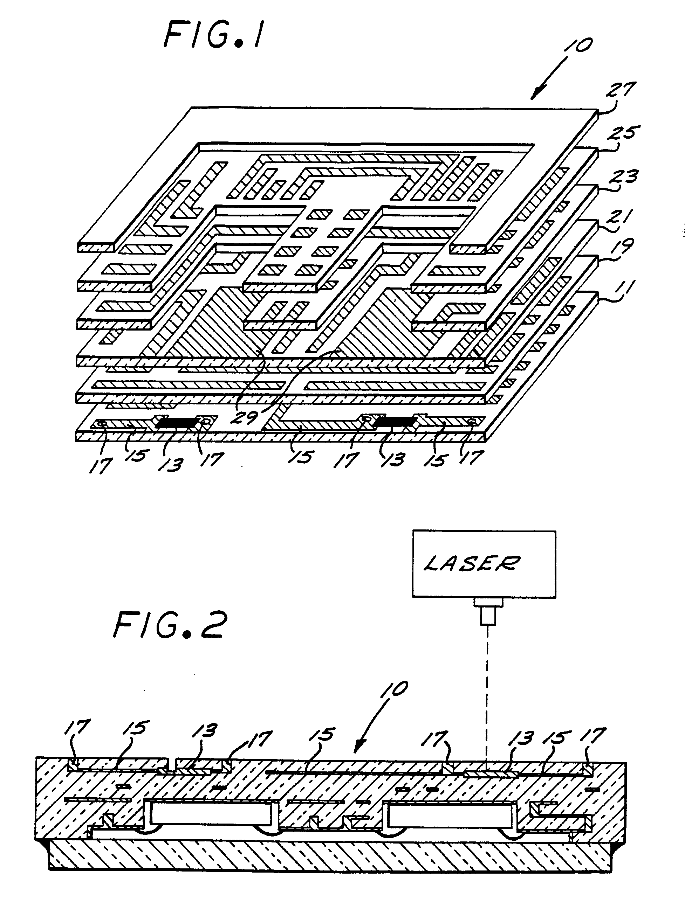

Referring now to FIG. 1, illustrated therein is an exploded schematic view of the layers of a hybrid multilayer circuit structure 10. By way of example, the multilayer circuit structure 10 may be provided pursuant to known dielectric tape technology. The multilayer circuit structure 10 includes a bottom dielectric layer 11 on which a plurality of resistors 13 are formed. As discussed further herein, another dielectric layer 19 is laminated on top of the bottom dielectric layer 11, thereby covering the resistors 13 as well as other passive circuit elements formed on the bottom dielectric layer. The resistors 13 are therefore referred to as buried resistors. Although not specifically shown, buried capacitors may also be formed between the dielectric layers 11, 19.

Conductor runs 15 provide terminations for the buried resistors 13, and provide conductive access to the resistors 13. The conductor runs 15 are further conductively coupled to via metallizations 17 which pass through vias to the bottom of the bottom layer 11. The via metallizations 17 allow for the testing of the values of the buried resistors 13 for trimming purposes. Although not shown, conductor runs may be formed on the bottom of the bottom dielectric layer 11 to provide for convenient access to the via metallizations 17.

By way of example, the buried resistors 13 may be fabricated using standard thick film techniques, or with other techniques by which such buried resistors may be formed (e.g., thin film techniques). By way of specific example, the metallization for the conductor runs 15 may be screen printed on the top surface of the dielectric layer 11, and the resistors 13 may be screen printed on the bottom surface of the dielectric layer 19. This would avoid printing over paste which had only been dried, and moreover avoids having to print on possibly uneven screen printed thickness. It further avoids the possible reaction of the second paste with the first paste while the second paste is drying.

As a specific example, the dielectric layer 11 may be formed of commercially available ceramic tape marketed by the E. I. Du Pont De Nemours Company of Wilmington, Delaware ("Du Pont") with the designation of #851AT. The resistors 13 may be formed with Series 1900 resistor material also available from Du Pont. The conductors 15 may be made of a thick film paste available from Du Pont and designated as 5717D; and the via metallizations may be made of thick film paste available from Du Pont and designated as 5718D. All of the foregoing materials may be utilized with a low temperature cofired process which utilizes a firing temperature of about 850°C.

The hybrid multilayer circuit structure 10 further includes internal dielectric layers 19, 21, 23 which may be made of the same ceramic tape as the bottom dielectric layer 11. The internal dielectric layers 19, 21, 23 include predetermined conductor runs, via metallizations, and buried circuit elements. The internal dielectric layer 21 is shown as including die bond pads 29, while the internal dielectric layer 23 is shown as including die cutouts. A wire bond dielectric layer 25 including conductor traces via metallizations is disposed on top of the internal dielectric layer 23, and also includes die cutouts in alignment with those of the internal dielectric layer 23. The die cutouts provide cavities for devices (not shown) that are to be bonded to the die bond pads 29. Such devices are connected to conductor traces on the wire bond dielectric layer 25 by wire bonding.

A package seal layer 27, which may be of glass or a conductive material, surrounds the outer perimeter of the multilayer circuit structure 10, and is intended to accept a cover for hermetically sealing the package after discrete circuit devices (not shown) are bonded and wired to the multilayer circuit structure 10. In practice, further package seal layers may be utilized to build an enclosing cavity.

It should be understood that the foregoing multilayer circuit structure 10 is only schematically illustrated and described, and actual implementations may include different layers and configurations. For example, the internal dielectric layers and the wire bond layer may be without die cutouts, and the die bond pads would be included on the wire bond layer.

After the hybrid multilayer circuit structure 10 is appropriately fabricated with known techniques such as one of the ceramic tape technologies, discrete circuit devices (not shown) are bonded and wired to the multilayer circuit structure 10, and the resulting structure is hermetically sealed. The sealed package is then ready for resistor trimming.

Referring now to FIG. 2, the buried resistors 13 in the hermetically sealed multilayer circuit structure 10 are trimmed with known laser trimming equipment. The outlines of the resistors 13 are visible through the bottom of the bottom layer 11 and are aligned with the laser trimming equipment. The laser has to cut through the bottom dielectric layer 11 as well as through the resistor material, and several passes of the laser may be required. The values of the resistors 13, which increase pursuant to trimming, are measured by use of the via metallizations 17. After the resistors 13 are trimmed, the laser cut openings in the bottom dielectric layer 11 may be sealed, for example with a sealing glass that does not cause the resistor material to drift.

By way of example, an Electro Scientific Industries, Inc., Model 44 laser trimmer may be used with the following trim parameters: L-cut trimming mode, 13.5 Amps, 5000 Hz laser pulse rate, 0.5 mm/sec speed, and −15% cutoff. The −15% cutoff indicates that trimming is terminated when the value of the resistor being trimmed reaches a value of 15% less than the desired value.

The foregoing technique of trimming buried resistors is further utilized with buried capacitors, which are fabricated with known processes. Generally, a buried capacitor includes two conductive plates separated by a dielectric. For example, one conductive plate may be a conductive area screen printed on the top surface of a lower dielectric layer, and the dielectric may be a dielectric region screen printed over the screen printed conductive area. The other conductive plate may be a conductive area screen printed on the bottom surface of a dielectric layer that overlies the lower dielectric layer in registration with the conductive area and dielectric region screen printed on the lower dielectric layer. Alternatively, the dielectric region may comprise dielectric tape.

A buried capacitor is trimmed by selectively removing part of one or both of the capacitor plates after the hybrid circuit containing the buried capacitor has been fired and sealed. Trimming a buried capacitor in such manner reduces its capacitance.

While the foregoing has been generally directed to a hybrid package, it should be appreciated that the invention is applicable to other hybrid multilayer circuit structures.

It should also be understood that the invention is not limited to buried trim resistors and capacitors formed on the bottom dielectric layer of a laminated ceramic tape structure. For example, buried trim resistors or capacitors may be formed on the internal dielectric layer immediately beneath the wire bond layer 25. The trim areas of such buried resistors or capacitors would be located so that laser cutting through the wire bond dielectric layer 25 would not destroy or damage any conductor runs, via metallizations or passive circuit components (e.g., resistors) formed on the wire bond dielectric layer. Buried resistors or capacitors formed adjacent to the wire bond layer 25 would be particularly advantageous for hybrid multilayer circuit structures fabricated with standard thick film techniques which utilize an insulating material.

It should be further understood that the invention is applicable to any buried resistors or capacitors which have trim areas that are accessible by laser cutting that does not damage or destroy conductive or circuit structures formed on dielectric layers that are effected by the laser cutting. In other words, the trim areas of the buried resistors or capacitors have to be appropriately located.

While the foregoing has been directed to trimming buried resistors and capacitors with a laser, the invention contemplates the use of other techniques for selectively removing resistor and capacitor material, including abrasive, air jet, or waterjet trimming. Also, the invention contemplates trimming other passive circuit components that may be buried in a hybrid multilayer circuit structure.

The foregoing described invention provides several advantages including the following. It provides for trim resistors and capacitors which do not utilize valuable top layer area, thereby allowing for denser discrete device packing. The invention further provides for trim resistors and capacitors which do not require extra processing steps for passivation. Also, the invention provides for trim resistors and capacitors which may be fabricated with known hybrid techniques.

## Claims

1. A process for trimming a passive circuit component formed within a hybrid multilayer circuit structure, comprising the steps of:
    forming a buried passive circuit component between two dielectric layers of a hybrid multilayer circuit structure;
    processing the multilayer circuit structure to provide a fired multilayer circuit structure; and
    selectively trimming the buried passive circuit component.

2. The process of Claim 1, wherein the step of trimming the buried passive circuit component includes the step of selectively removing part of the material of the buried passive circuit component.

3. The process of Claim 2 wherein the step of selectively removing part of the material of the buried passive circuit component includes the step of selectively removing part of the material of the buried passive circuit component with a laser beam.

4. The process of Claim 3 further including the step of sealing openings in the multilayer circuit structure made by the selective removal of part of the material of the buried passive circuit component.

5. The process of Claim 1 wherein the step of forming a buried passive circuit component includes the step of forming a buried resistor.

6. The process of Claim 2 wherein the step of forming a buried resistor includes the step of forming a thick film resistor.

7. The process of Claim 1 wherein the step of forming a buried passive circuit component includes the step of forming a buried capacitor.

## Patentansprüche

1. Ein Verfahren zur Abgleichung einer passiven Schaltungskomponente, welche innerhalb einer hybriden Vielschichtschaltungsstruktur gebildet ist, mit den Schritten:
    Bilden einer vergrabenen passiven Schaltungskomponente zwischen zwei dielektrischen Schichten einer hybriden Vielschichtschaltungsstruktur;
    Verarbeiten der Vielschichtschaltungsstruktur, am eine eingebrannte Vielschichtschalungsstruktur bereitzustellen; und
    selektives Abgleichen der vergrabenen passiven Schaltungskomponente.

2. Das Verfahren nach Anspruch 1, worin der Schritt des Abgleichens der vergrabenen passiven Schaltungskomponente den Schritt des selektiven Entfernens eines Teils des Materials der vergrabenen Schaltungskomponente beinhaltet.

3. Das Verfahren nach Anspruch 2, worin der Schritt des selektiven Entfernens des Teils des Materials der vergrabenen passiven Schaltungskomponente den Schritt des selektiven Entfernens eines Teils des Materials der vergrabenen passiven Schaltungskomponente mit einem Laserstrahl beinhaltet.

4. Das Verfahren nach Anspruch 3, welches des weiteren den Schritt des Abdichtens von Öffnungen in der Vielschichtschaltungsstruktur beinhaltet, welche durch das selektives Entfernen eines Teils des Materials der vergrabenen passiven Schaltungskomponente erzeugt werden.

5. Das Verfahren nach Anspruch 1, worin der Schritt des Bildens einer vergrabenen passiven Schaltungskomponente den Schritt des Bildens eines vergrabenen Widerstands beinhaltet.

6. Das Verfahren nach Anspruch 2, worin der Schritt des Bildens eines vergrabenen Widerstands den Schritt des Bildens eines Dickfilmwiderstands beinhaltet.

7. Das Verfahren nach Anspruch 1, worin der Schritt des Bildens einer vergrabenen passiven Schaltungskomponente den Schritt des Bildens eines vergrabenen Kondensators beinhaltet.

## Revendications

1. Procédé pour ajuster un composant de circuit passif formé au sein d'un structure de circuit multicouche hybride, comprenant les étapes de:

formation d'une composant de circuit passif noyé entre deux couches diélectriques d'une structure de circuit multicouche hybride;

traitement de la structure de circuit multicouche pour obtenir une structure de circuit multicouche cuite; et

ajustage sélectif du composant de circuit passif noyé.

2. Procédé selon la revendication 1, dans lequel l'étape d'ajustage du composant de circuit passif noyé comprend l'étape d'enlèvement sélectif d'une partie du matériau du composant de circuit passif noyé.

3. Procédé selon la revendication 2, dans lequel l'étape d'enlèvement sélectif d'une partie du matériau du composant de circuit passif noyé comprend l'étape d'enlèvement sélectif d'une partie du matériau du composant de circuit passif noyé avec un faisceau laser.

4. Procédé selon la revendication 3, comprenant en outre l'étape de colmatage d'ouvertures dans la structure de circuit multicouche produites par d'enlèvement sélectif d'une partie du matériau du composant de circuit passif noyé.

5. Procédé selon la revendication 1, dans lequel l'étape de formation d'un composant de circuit passif noyé comprend l'étape de formation d'une résistance noyée.

6. Procédé selon la revendication 2, dans lequel l'étape de formation d'une résistance noyée comprend l'étape de formation d'une résistance en couche épaisse.

7. Procédé selon la revendication 1, dans lequel l'étape de formation d'un composant de circuit passif noyé comprend l'étape d'une capacité noyée.

# FIG.1

# FIG.2

LASER